# EUROPÄISCHE PATENTSCHRIFT

(11) **EP 2 223 343 B1**
(45) Veröffentlichungstag und Bekanntmachung des Hinweises auf die Patenterteilung: **19.10.2011**
(21) Anmeldenummer: 08801500.3
(22) Anmeldetag: 30.07.2008
(51) Int. Cl.: H01L 31/0203, G01J 5/04

(54) **VORRICHTUNG MIT EINER ABGESCHIRMTEN SANDWICHSTRUKTUR ZUR DETEKTION VON WÄRMESTRAHLUNG UND VERWENDUNG DER VORRICHTUNG**
APPARATUS HAVING A SCREENED SANDWICH STRUCTURE FOR DETECTING THERMAL RADIATION, AND USE OF THE APPARATUS
DISPOSITIF MUNI D'UNE STRUCTURE EN SANDWICH BLINDÉE POUR DÉTECTER UN RAYONNEMENT THERMIQUE ET UTILISATION DU DISPOSITIF

(30) Priorität: 17.12.2007 DE 102007062688
(43) Veröffentlichungstag der Anmeldung: 01.09.2010
(73) Patentinhaber: Pyreos Ltd., EH9 3JF Edinburgh (GB)
(72) Erfinder: WRIGHT, Jeffrey, East Lothian EH21 6QG (GB)
(74) Vertreter: Fischer, Ernst
(86) Internationale Anmeldenummer: PCT/EP2008/006289
(87) Internationale Veröffentlichungsnummer: WO 2009/077016

(56) Entgegenhaltungen:
- DE-A1-102004 002 163
- JP-A- 9 126 883

## Beschreibung

Die Erfindung betrifft eine Vorrichtung zur Detektion von Wärmestrahlung mit mindestens einem abgeschirmten, thermischen Detektorelement zur Umwandlung der Wärmestrahlung in ein elektrisches Signal. Neben der Vorrichtung wird eine Verwendung der Vorrichtung angegeben.

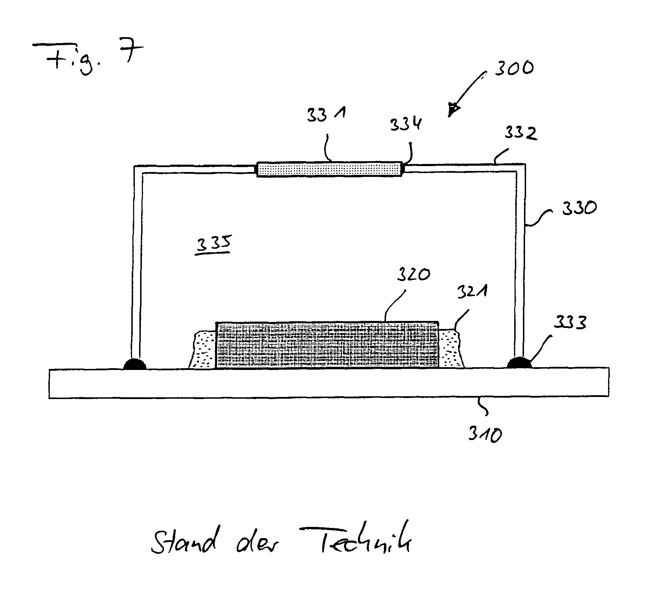

Eine herkömmliche Vorrichtung 300 zur Detektion von Wärmestrahlung ist in Figur 7 gezeigt. Die Vorrichtung 300 weist ein Substrat 310 und einen Sensor 320 auf, der auf dem Substrat 310 mittels einer Vergussmasse 321 befestigt ist. Ferner weist die Vorrichtung 300 ein Schutzgehäuse 330 auf, das über den Sensor 320 gestülpt an dem Substrat 310 mittels einer hermetisch dichten Bonding-Verbindung 333 befestigt angeordnet ist. Das Schutzgehäuse 330 ist derart dimensioniert, dass das Schutzgehäuse 330 den Sensor 320 nicht direkt berührt, so dass zwischen dem Sensor 320 und dem Schutzgehäuse 330 ein Innenraum 335 ausgebildet ist. Das Schutzgehäuse 330 weist eine Oberseite 332 auf, die dem Sensor 320 abgewandt angeordnet ist. In der Oberseite 332 ist eine Fensteröffnung 334 vorgesehen, die so oberhalb des Sensors 320 angeordnete ist, dass Licht von außerhalb des Schutzgehäuses 330 auf den Sensor 320 treffen kann. In die Öffnung 334 ist ein Glasfenster 331 hermetisch dicht eingesetzt.

Das Schutzgehäuse 330 ist aus Metall gefertigt, so dass der Sensor 320 von dem Schutzgehäuse 330 elektromagnetisch abgeschirmt ist. Ferner ist das Glasfenster 331 derart gasdicht in die Fensteröffnung 334 eingesetzt und die Bonding-Verbindung 333 derart gasdicht ausgebildet, dass der Innenraum 335 evakuiert oder mit Inertgas bzw. Wasserstoff beaufschlagt ist. Dadurch ist der Sensor 320 vor atmosphärischen Einflüssen geschützt. Nachteilig ist jedoch, dass die Vorrichtung 300 aufgrund der großen Bauhöhe des Schutzgehäuses 330 einen großen Platzbedarf hat. Ferner ist bei der Herstellung der Vorrichtung 300 sowohl das Einsetzen und das Abdichten des Glasfensters 331 in die Fensteröffnung 334 als auch das Ausbilden der hermetisch dichten Bonding-Verbindung 333 aufwendig und kostenintensiv.

Eine Vorrichtung zur Detektion von Wärmestrahlung ist beispielsweise in DE 100 04 216 A1 beschrieben. Diese Vorrichtung wird als Pyrodetektor bezeichnet. Das Detektorelement ist ein pyroelektrisches Detektorelement. Es weist einen Schichtaufbau mit zwei Elektrodenschichten und einer zwischen den Elektrodenschichten angeordneten pyroelektrischen Schicht mit pyroelektrisch sensitivem Material auf. Dieses Material ist Bleizirkonattitanat (PZT). Die Elektroden bestehen beispielsweise aus Platin oder aus einer die Wärmestrahlung absorbierenden Chrom-Nickel-Legierung. Das thermische Detektorelement ist mit einem Detektorträger aus Silizium (Silizium-Wafer) verbunden. Zwischen dem Detektorelement und dem Detektorträger ist eine Isolationsschicht zur elektrischen und thermischen Isolierung des Detektorelements und des Detektorträgers voneinander angeordnet. Die Isolationsschicht verfügt dabei über einen evakuierten Hohlraum, der sich über eine Grundfläche des Detektorelements hinweg erstreckt, eine Stützschicht des Hohlraums und eine Abdeckung der Stützschicht und des Hohlraums. Die Stützschicht besteht aus Polysilizium. Die Abdeckung ist aus einem Bor-Phosphor-Silikat-Glas (BPSG). Zum Auslesen, Verarbeiten und/oder Weiterleiten des vom Detektorelement erzeugten elektrischen Signals ist im Detektorträger ein Ausleseschaltkreis integriert. Der Ausleseschaltkreis ist durch die CMOS(Complementary Metalloxide Semiconductors) -Technik realisiert.

Eine damit vergleichbare Vorrichtung zur Detektion von Wärmestrahlung ist aus der DE 195 25 071 A1 bekannt. Das thermische Detektorelement ist ebenfalls ein oben beschriebenes pyroelektrisches Detektorelement. Das Detektorelement ist auf einem mehrschichtigen Detektorträger angeordnet. Über eine seiner Elektrodenschichten ist das Detektorelement auf einer Siliziumschicht des Detektorträgers aufgebracht. Die Siliziumschicht befindet sich auf einer elektrisch isolierenden Membran des Detektorträgers. Die Membran besteht beispielsweise aus einer Si₃N₄/SiO₂/Si₃N₄ -Dreifachschicht. Die Membran ist wiederum auf einem Silizium-Substrat des Detektorträgers aufgebracht. Das Silizium-Substrat weist ein Bestrahlungsfenster (Detektionsfenster) auf mit einer Grundfläche, die im Wesentlichen einer Grundfläche des pyroelektrischen Detektorelements entspricht. Das Bestrahlungsfenster ist ein Ausschnitt des Silizium-Substrats. Dabei ist Trägermaterial (Silizium) des Substrats bis zur Membran hin entfernt. Durch das Bestrahlungsfenster gelangt die Wärmestrahlung auf das Detektorelement und führt dort zu einem auswertbaren elektrischen Signal. Dazu zeichnet sich die Membran durch eine geeignete Transmission für die Wärmestrahlung aus. In der Siliziumschicht, seitlich zum Detektorelement versetzt, ist ein Ausleseschaltkreis für das elektrische Signal integriert. Der Detektorträger fungiert auch als Schaltungsträger des Ausleseschaltkreises.

Bei den bekannten Vorrichtungen kann eine Vielzahl von Detektorelementen vorhanden sein (Detektorelement-Array). Dabei ist das elektrische Signal jedes der Detektorelemente separat auszulesen. Üblicherweise sind dazu die Elektrodenschichten jedes der Detektorelemente über Bonddrähte elektrisch kontaktiert. Dies bedeutet aber einen erheblichen Platzbedarf für eine Verdrahtung der Detektorelemente mit dem Erlebnis einer begrenzten, relativ niedrigen Detektorelement-Dichte (Anzahl der Detektorelemente pro Oberflächenabschnitt des Detektorträgers).

In DE 10 2004 002 163 A1 ist ein Gasmodul mit einem Strahlungsdetektor beschrieben, der einen Thermopile-Chip mit einer Membran und einer Absorberschicht aufweist, einen Kappen-Chip, der an dem Thermopile-Chip über eine vakuumdichte Verbindung befestigt ist, derartig, dass die Membran zwischen Kavitäten des Thermopile-Chips und des Kappen-Chips angeordnet ist und ein auf dem Kappen-Chip über eine Klebstoffschicht befestigtes Filterplättchen zur Filterung von Infrarotstrahlung. In JP 09126883 ist eine Vorrichtung mit einem pyroelektrischen Element, das auf einer Leiterplatte aufgebaut ist, die von einer metallischen Kappe umhüllt ist. In der metallischen Kappe ist ein Filter 5 in einem Fenster eingebaut. Weitere Beispiele werden in GB2424699, JP61286722 und JP02141628 offenbart.

Aufgabe der Erfindung ist es, eine Vorrichtung zur Detektion von Wärmestrahlung anzugeben, die einen im Vergleich zum Stand der Technik geringeren Platzbedarf aufweist und einfach und kostengünstig herstellbar ist.

Zur Lösung der Aufgabe wird eine Vorrichtung zur Detektion von Wärmestrahlung angegeben, aufweisend ein Substrat, ein auf dem Substrat angebrachtes und ein elektrisch leitendes Material aufweisendes Schutzgehäuse mit einer dem Substrat abgewandten Oberseite, in der eine Öffnung vorgesehen ist, und einen auf dem Substrat innerhalb des Schutzgehäuses angebrachten Stapel mit mindestens einem Detektorträger mit mindestens einem thermischen Detektorelement zur Umwandlung der Wärmestrahlung in ein elektrisches Signal, mindestens einem Schaltungsträger mit mindestens einer Ausleseschaltung zum Auslesen des elektrischen Signals, und mindestens einer Abdeckung zum Abdecken des Detektorelements, wobei der Detektorträger zwischen dem Schaltungsträger und der Abdeckung angeordnet ist, der Detektorträger und die Abdeckung derart aneinander angeordnet sind, dass zwischen dem Detektorelement des Detektorträgers und der Abdeckung mindestens ein, vom Detektorträger und von der Abdeckung begrenzter, erster Stapelhohlraum des Stapels vorhanden ist, der Schaltungsträger und der Detektorträger derart aneinander angeordnet sind, dass zwischen dem Detektorträger und dem Schaltungsträger mindestens ein, vom Schaltungsträger und vom Detektorträger begrenzter, zweiter Stapelhohlraum des Stapels vorhanden ist, und wobei der Stapel eine dem Substrat angewandte Stapeloberseite aufweist, mit der der Stapel mit der Öffnung in Eingriff steht, so dass die Stapeloberseite von außerhalb des Schutzgehäuses zugänglich ist. Erfindungsgemäß findet die Vorrichtung in Bewegungsmeldern, Präsenzmeldern und Wärmebildkameras Verwendung. Der erste Stapelhohlraum und/oder der zweite Stapelhohlraum sind bevorzugt evakuiert oder evakuierbar.

Der Stapel ist als eine kompakte, Platz sparende "Sandwich"-Struktur aus Detektorträger, Schaltungsträger und Abdeckung realisiert. Durch die Abdeckung ist das Detektorelement vor einem schädlichen Umwelteinfluss geschützt. Der Umwelteinfluss ist beispielsweise Staub, Luftfeuchtigkeit oder eine ätzende Chemikalie, die einen Bestandteil des Detektorelements angreifen oder die Funktionsweise des Detektorelements beeinträchtigen würde.

Das Schutzgehäuse ist aus elektrisch leitendem Material gefertigt, so dass der Stapel von dem Schutzgehäuse nach außen elektromagnetisch abgeschirmt ist. Dadurch, dass der Stapel aufgrund seiner Sandwich-Struktur gegen schädliche Umwelteinflüsse unempfindlich ist, braucht das Schutzgehäuse nicht derart eingerichtet zu sein, dass es den Stapel beispielsweise vor Staub, Luftfeuchtigkeit oder eine ätzende Chemikalie schützt. Somit ist das Schutzgehäuse erfindungsgemäß lediglich mit einer Öffnung in der Oberseite versehen, mit der der Stapel in Eingriff steht. Der Stapel kann entweder nur in die Öffnung eintauchen und somit die Öffnung nur teilweise durchdringen, vollständig in die Öffnung eingesetzt sein und dabei plan mit der Außenseite der Oberseite des Schutzgehäuses abschließen, oder durch die Öffnung durchgesteckt sein und dabei an der Außenseite der Oberseite des Schutzgehäuses nach außen vorstehen.

Dadurch ist die Bauhöhe des Schutzgehäuses im Wesentlichen gleich der Bauhöhe des Stapels, so dass vorteilhaft die Bauhöhe der Vorrichtung gering ist. Ferner braucht der Stapel nicht von dem Schutzgehäuse hermetisch abgeschossen zu sein, wodurch das Schutzgehäuse einfach ausgeführt sein kann. So ist in dem Schutzgehäuse einfach die Öffnung vorgesehen, durch die der Stapel von außerhalb des Schutzgehäuses zugänglich ist, und die Befestigung des Schutzgehäuses auf dem Substrat braucht eventuellen Dichtigkeitsanforderungen nicht zu genügen.

Der Auswerteschaltkreis kann direkt im Schaltungsträger integriert sein, beispielsweise durch die CMOS-Technik. Denkbar ist auch, dass der Schaltungsträger lediglich eine Verdrahtung des Detektorelements bereitstellt. Durch die Verdrahtung ist das Detektorelement mit einem im Schaltungsträger angeordneten internen ASIC (Applied Specific Integrated Circuit, anwendungsspezifische integrierte Schaltung) oder mit einem externen ASIC elektrisch verbunden. Das externe ASIC kann gebondet sein. Vorteilhaft ist das externe ASIC mittels "Flip Chip"-Technik (siehe unten) kontaktiert. Die Stapelhohlräume sorgen dafür, dass das Detektorelement von dem Schaltungsträger und der Abdeckung thermisch weitgehend voneinander entkoppelt sind.

Die zu detektierende Wärmestrahlung weist eine Wellenlänge von über 1 µm auf. Vorzugsweise ist die Wellenlänge aus dem Bereich von 5 bis 15 µm ausgewählt. Das thermische Detektorelement basiert beispielsweise auf dem Seebeck-Effekt. Vorzugsweise ist das thermische Detektorelement ein pyroelektrisches Detektorelement. Das pyroelektrische Detektorelement besteht, wie eingangs beschrieben, aus einer pyroelektrischen Schicht mit einem pyroelektrisch sensitiven Material und beidseitig angebrachten Elektrodenschichten. Das pyroelektrisch sensitive Material ist beispielsweise eine Keramik wie Lithiumniobat (LiNbO₃) oder Bleizirkonattitanat. Denkbar ist auch ein ferroelektrisches Polymer wie Polyvinylidenfluorid (PVDF). Als Elektrodenmaterial der Elektrodenschichten kommt beispielsweise Platin oder eine Platinlegierung in Frage. Denkbar ist auch eine Chrom-Nickel-Elektrode oder eine Elektrode aus einem elektrisch leitenden Oxid. Das Detektorelement verfügt beispielsweise über eine rechteckige Grundfläche mit einer Kantenlänge von 25 µm bis 200 µm.

Unabhängig vom Effekt, der zur Detektion der Wärmestrahlung ausgenutzt wird, ist eine Absorption der Wärmestrahlung durch jeweils ein den entsprechenden Effekt auslösendes, thermisch sensitives Material des Detektorelements notwendig. Die Absorption erfolgt direkt durch das thermisch sensitive Material. Denkbar ist aber auch, dass die Wärmestrahlung durch eine Elektrode bzw. Elektrodenschicht des Detektorelements absorbiert wird. Zudem ist es auch möglich, dass die Wärmestrahlung durch einen Absorptionsgegenstand in unmittelbarer Nähe des Detektorelements absorbiert und eine dadurch aufgenommene Wärmemenge durch Konvektion oder Wärmeleitung an das thermisch sensitive Material abgegeben wird. Der Absorptionsgegenstand fungiert als Energietransmitter. Beispielsweise ist der Absorptionsgegenstand als Beschichtung direkt auf das Detektorelement aufgebracht.

Der Stapel der Vorrichtung zur Detektion der Wärmestrahlung ist vorzugsweise derart ausgestaltet, dass die Wärmestrahlung direkt auf das Detektorelement gelangt. Dazu weisen in einer besonderen Ausgestaltung der Detektorträger, der Schaltungsträger und/oder die Abdeckung mindestens ein Bestrahlungsfenster mit einer bestimmten Transmission für die Wärmestrahlung zum Bestrahlen des Detektorelements mit der Wärmestrahlung auf. Das Bestrahlungsfenster ist in der Abdeckung, im Detektorträger und/oder im Schaltungsträger integriert. Das Detektorelement und das Bestrahlungsfenster sind derart aneinander angeordnet, dass die Bestrahlung des Detektorelements von einer dem Detektorträger abgewandten Vorderseite des Detektorelements (Vorderseitenbestrahlung) und/oder von einer dem Detektorträger zugewandten Rückseite des Detektorelements (Rückseitenbestrahlung) erfolgt. Das Bestrahlungsfenster weist in Richtung des Detektionselements eine bestimmte Transmission auf. Die Transmission ist möglichst hoch und beträgt beispielsweise über 50% und insbesondere Über 70% bis nahe 95%.

Als Material des Detektorträgers, des Schaltungsträgers und der Abdeckung kommen beliebige Materialien in Frage. Halbleitende Materialien, beispielsweise elementares Germanium oder verschiedene halbleitende Verbindungen eignen sich wegen der Möglichkeit der Integration von elektrischen Schaltungen oder Bauteilen besonders. Gemäß einer besonderen Ausgestaltung weisen der Detektorträger, der Schaltungsträger und/oder die Abdeckung Silizium auf. Es wird jeweils ein Silizium-Substrat als Abdeckung, als Schaltungsträger und als Detektorträger verwendet. Durch die CMOS-Technik können beliebige Strukturen und Funktionalitäten in die Substrate integriert werden. Da Silizium bezüglich der Wärmestrahlung einen niedrigen Absorptionskoeffizienten aufweist, kann zudem das Bestrahlungsfenster sehr leicht in einem Silizium-Substrat integriert werden: Das Silizium-Substrat selbst bildet das Bestrahlungsfenster. Durch eine geeignete Anordnung der entsprechenden Funktionalitäten im Silizium-Substrat wird dafür gesorgt, dass die Wärmestrahlung ungehindert, also ohne Abschattung, auf das Detektorelement gelangt.

Die Transmission hängt nicht nur vom Absorptionskoeffizienten des Materials ab, aus dem das Bestrahlungsfenster besteht. Entscheidend ist auch eine Dicke des Bestrahlungsfensters. Vorteilhaft wird das Bestrahlungsfenster von einem ausgedünnten Bereich des Detektorträgers oder des Schaltungsträgers gebildet. In einer besonderen Ausgestaltung ist das Detektorelement gegenüber einer Schaltungsträgerausnehmung des Schaltungsträgers oder gegenüber einer Abdeckungsausnehmung der Abdeckung angeordnet. Die Schaltungsträgerausnehmung und die Abdeckungsausnehmung sind jeweils ein Bereich des Schaltungsträgers bzw. der Abdeckung mit relativ niedriger Dicke. In diesen Bereichen sind der Schaltungsträger und die Abdeckung ausgedünnt, beispielsweise durch Materialabtrag. Die Ausnehmungen bilden das Bestrahlungsfenster, das im Schaltungsträger bzw. in der Abdeckung integriert ist und durch das die Wärmestrahlung auf das Detektorelement gelangt. Das Detektorelement ist vorzugsweise von der jeweiligen Ausnehmung beabstandet. Die Abdeckungsausnehmung ist Bestandteil des ersten Stapelhohlraums zwischen dem Detektorträger und der Abdeckung. Die Schaltungsträgerausnehmung ist Bestandteil des zweiten Stapelhohlraums zwischen dem Detektorträger und dem Schaltungsträger.

Erfindungsgemäß sind der Detektorträger und der Schaltungsträger und/oder der Detektorträger und die Abdeckung durch einen Stoffschluss und insbesondere durch einen hermetischen Stoffschluss fest miteinander verbunden. Zum festen Verbinden des Detektorträgers und des Schaltungsträgers und/oder zum festen Verbinden des Detektorträgers und der Abdeckung wird ein Stoffschluss hergestellt. Der Stoffschluss ist derart ausgestaltet, dass die evakuierbaren Stapelhohlräume gebildet werden. Komponenten des Stapels, die sich in den Stapelhohlräumen befinden, beispielsweise das Detektorelement, sind durch den hermetischen Stoffschluss von einer Umgebung abgeschirmt. Es findet kein Stoffaustausch mit der Umgebung statt. Somit kann die Vorrichtung auch in einer aggressiven Umgebung eingesetzt werden. Durch den hermetischen Stoffschluss können die Stapelhohlräume evakuiert werden. Dies erhöht die Sensitivität gegenüber der zu detektierenden Wärmestrahlung.

Die Stoffschlüsse zwischen dem Detektorträger und der Abdeckung und zwischen dem Detektorträger und dem Schaltungsträger können nacheinander oder gleichzeitig hergestellt werden. Der jeweilige Stoffschluss kann von einem beliebigen Stoff, beispielsweise einem Klebstoff gebildet werden. Besonders vorteilhaft ist es, mit dem Stoffschluss gleichzeitig eine elektrische Kontaktierung zwischen den Elektrodenschichten des Detektorelements und der Ausleseschaltung herzustellen. Dazu weist in einer besonderen Ausgestaltung der Stoffschluss einen elektrisch leitfähigen Stoff auf. Dies betrifft insbesondere den Stoffschluss zwischen dem Schaltungsträger und Detektorträger. Aber auch ein Stoffschluss mit einem elektrischleitfähigen Stoff kann zwischen der Abdeckung und dem Detektorträger vorteilhaft sein, wenn in der Abdeckung Verdrahtungsbestandteile für das Detektorelement integriert sind.

Prädestiniert für die Herstellung des Stoffschlusses ist die so genannte "Flip-Chip"-Technik. Darunter wird ein Montageverfahren aus dem Bereich der Aufbau und Verbindungstechnik (AVT) verstanden, die sich vor allen Dingen in der Mikroelektronik zur Kontaktierung von Halbleiter-Mikrochips oder von integrierten Schaltungen in ungehäuster Form bewährt hat. Bei der Flip-Chip-Technik wird ein Chip direkt, ohne weitere Anschlussdrähte, mit einer aktiven Kontaktierungsseite nach unten zum Substrat (Schaltungsträger) hin montiert. Eine Montage erfolgt über sogenannte "Bumps" aus elektrisch leitendem Material. Dies führt zu sehr kurzen Leiterlängen. Dies wird hier ausgenutzt: Es resultiert ein kompakter Aufbau. Durch die sehr kurzen Leiterlängen werden zudem unerwünschte, das auszulesende elektrische Signal störende Streuinduktivitäten und - kapazitäten auf ein Mindestmaß reduziert. Dieser Einfluss wirkt sich insbesondere vorteilhaft bei einer relativ kleinen Anzahl von zu kontaktierenden Detektorelementen aus. Mit Hilfe der Flip-Chip-Technik kann zudem eine Vielzahl von elektrischen Verbindungen gleichzeitig hergestellt werden, was einen enormen Zeit- und damit Kostenvorteil mit sich bringt.

Zur Realisierung der "Flip-Chip"-Technik und damit zum Herstellen des Stoffschlusses können verschiedene Techniken eingesetzt werden. In einer besonderen Ausgestaltung wird zum Herstellen des Stoffschlusses ein aus der Gruppe Kleben, Löten und/oder Bonden ausgewähltes Verfahren durchgeführt. Dabei sind adhäsives Bonden oder eutektisches Bonden denkbar. Zum Löten werden Bumps aus einem Lot (Lotkugeln) auf einem oder auf beide miteinander zu verbindenden Träger bzw. Bestandteile der Vorrichtung aufgebracht. Die genannten Verfahren sind an sich gegenüber dem Kleben zu bevorzugen, da es bei einem Klebstoff zu Ausgasungen von organischen Bestandteilen (Lösungsmittel, Klebstoffkomponente, ...) kommen kann. Dies spielt insbesondere, im Hinblick auf die Evakuierung der Stapelhohlräume eine Rolle. Nichtsdestotrotz kann es aber notwendig oder vorteilhaft sein, auf das Kleben zurückzugreifen.

Beim Kleben kann auf verschiedene Varianten zurückgegriffen werden: Das Kleben kann mit einem elektrisch nicht leitfähigem Klebstoff erfolgen. Dazu sind auf Kontaktflächen des entsprechenden Trägers Bumps aufgebracht. Die Bumps bestehen beispielsweise aus Aluminium oder Gold. Danach wird auf den Träger eine Klebstoffschicht des Klebstoffs aufgetragen und das entsprechende Gegenstück auf der Klebstoffschicht angeordnet. Beim Trocknen schrumpft der Klebestoff und es bilden sich die elektrischen Kontakte.

Ebenso kann zum Kleben ein isotrop leitfähiger Klebstoff verwendet werden. Auf die Kontaktflächen eines Trägers wird leitfähiger Klebstoff aufgebracht. Danach wird das Gegenstück mit seinen Kontaktflächen auf die Klebepunkte gesetzt. Der Klebstoff kann thermisch oder mittels UV-Strahlung ausgehärtet werden und stellt so den elektrisch leitfähigen Stoffschluss her.

Alternativ dazu wird ein anisotrop leitfähiger Klebstoff verwendet. Anisotrop leitfähiger Klebstoff ist ein Verbundmaterial aus elektrisch nicht leitfähigem Klebstoff und darin mit geringem Füllgrad enthaltenen, elektrisch leitfähigen Partikeln. Der anisotrop leitfähige Klebstoff wird auf den Kontaktflächen des Trägers aufgetragen. Durch den geringen Füllgrad stehen die elektrisch leitfähigen Partikel nach dem Auftragen nicht in Verbindung zueinander. Es bildet sich keine elektrischleitfähige Verbindung. Beim Aufsetzendes Gegenstücks wird der elektrisch nichtleitfähige Klebstoff verdrängt, bis die Partikel zwischen den Kontaktflächen des Trägers und den Kontaktflächen des Gegenstücks eingeklemmt werden und eine elektrisch leitfähige Verbindung zwischen den Kontaktflächen entsteht.

Gemäß einer besonderen Ausgestaltung des Verfahrens werden während und/oder nach dem festen Verbinden der erste Stapelhohlraum und/oder der zweite Stapelhohlraum evakuiert. Beispielsweise erfolgt das Herstellen des Stoffschlusses zwischen den Bestandteilen des Stapels im Vakuum. Mit der Ausbildung des Stoffschlusses wird der jeweilige Stapelhohlraum evakuiert. Denkbar ist auch, dass die Stapelhohlräume zunächst hergestellt und im Nachhinein evakuiert werden. Auch hier gilt: Die Stapelhohlräume können nacheinander oder gleichzeitig evakuiert werden. Zum gleichzeitigen Evakuieren können die Stapelhohlräume isobar miteinander verbunden sein. Dies bedeutet, dass der Druck in den beiden Stapelhohlräumen gleich ist.

Die Vorrichtung kann ein einziges Detektorelement aufweisen. Im Hinblick auf eine Anwendung der Vorrichtung als Präsenzmelder oder insbesondere als Wärmebildkamera ist es aber vorteilhaft bzw. notwendig, dass mehrere Detektorelemente vorhanden sind. In einer besonderen Ausgestaltung ist daher mindestens ein Detektorarray mit mehreren Detektorelementen vorhanden. Ein Detektorelement ist dabei ein Pixel des Detektorarrays. Das Detektorarray zeichnet sich beispielsweise durch eine spalten und/oder zeilenförmige Anordnung der Detektorelemente aus. Bei einer zeilenförmigen oder spaltenförmigen Anordnung sind die Detektorelemente eindimensional in einer Richtung verteilt. Bei einer spalten- und zeilenförmigen Anordnung liegt eine zweidimensionale Verteilung vor. Das Detektorarray besteht beispielsweise aus 240 x 320 einzelnen Elementen. Dies entspricht dem relativ niedrigen Auflösungsstandard QVGA. Denkbar ist übrigens auch eine willkürliche, flächige Verteilung der Detektorelemente. Für jedes der Detektorelemente kann ein eigenes Bestrahlungsfenster vorgesehen sein. Vorteilhaft ist aber, dass die Vorrichtung ein einziges Bestrahlungsfenster für mehrere oder für alle Detektorelemente aufweist. Damit kann die Herstellung der Vorrichtung vereinfacht werden.

Gemäß einer weiteren Ausgestaltung weist der Stapel eine Umhüllung auf. Der Stapel wird in einer Umhüllung angeordnet. Die Umhüllung schützt den Stapel mit seinen Bestandteilen vor schädlichen Umwelteinflüssen, beispielsweise Feuchtigkeit, oder vor mechanischer Zerstörung. Zu beachten ist dabei lediglich, dass die Bestrahlung des Detektorelements durch die Umhüllung nicht beeinträchtigt wird. Dazu wird ein Bestrahlungsfenster mit hoher Transmission für die Wärmestrahlung in die Umhüllung integriert.

Die Umhüllung kann dabei ein Gehäuse aus einem beliebigen Material sein. Vorzugsweise ist die Umhüllung eine Vergussmasse. Dazu wird zum Anordnen der Umhüllung ein aus der Gruppe Spritzgussverfahren oder Moldverfahren ausgewähltes Verfahren durchgeführt. Diese Verfahren sind aus Kostengründen besonders vorteilhaft. Dabei wird un- oder teilvernetzter Kunststoff auf den Stapel aufgebracht. Nach dem Auftragen wird der Kunststoff thermisch induziert oder durch Bestrahlung mit UV-Licht ausgehärtet. Zur Integration des Bestrahlungsfensters wird beispielsweise eine Maske benutzt, die nach dem Anordnen des Kunststoffs oder nach dem Aushärten des Kunststoffs entfernt wird. Dies gelingt beispielsweise durch Transfermolden mit einem gefederten Insert. Denkbar ist auch die Verwendung eines Bestrahlungsfensters aus einem Material mit hoher Transmission für die Wärmestrahlung, die nach dem Auftragen und Aushärten des Kunststoffs in der Umhüllung verbleibt.

Bevorzugt ist, dass das elektrisch leitende Material des Schutzgehäuses Metall aufweist.

Dadurch ist vorteilhaft erreicht, dass das Schutzgehäuse eine ausreichende Festigkeit bei günstigen Herstellungskosten hat.

Ferner ist es bevorzugt, dass die Öffnung des Schutzgehäuses derart ausgebildet ist, dass der Stapel in die Öffnung eingepasst ist, und/oder dass das Schutzgehäuse derart konstruiert ist, dass ihre Oberseite mit der Stapeloberseite plan abschließt.

Dadurch ist der Stapel in die Öffnung versenkt angeordnet, so dass die Bauhöhe der Vorrichtung vorteilhaft gering ist. Somit ist der Platzbedarf der Vorrichtung niedrig. Ferner ist der Stapel durch die Öffnung gut zugänglich angeordnet, so dass die Funktionalität der Vorrichtung zur Detektion von Wärmestrahlung hoch ist. Außerdem ist vorteilhaft ein Spalt, der zwischen dem Stapel und dem Schutzgehäuse konstruktiv bedingt vorgesehen ist, klein. Dadurch ist der Stapel von dem Schutzgehäuse effektiv geschützt und abgeschirmt.

Bevorzugt weist das Schutzgehäuse einen Fuß auf, mit dem das Schutzgehäuse an dem Substrat befestigt ist. Vorteilhaft braucht die Verbindung zwischen dem Fuß und dem Substrat nur derart stabil ausgeführt zu sein, dass die Verbindung üblichen Festigkeitsanforderungen genügt. Eine hermetisch dichte Ausführung der Verbindung ist nicht erforderlich.

Außerdem ist es bevorzugt, dass das Schutzgehäuse im Abstand von dem Stapel angeordnet ist, so dass im Inneren des Schutzgehäuses zwischen dem Schutzgehäuse und dem Stapel ein Hohlraum ausgebildet ist. Dadurch könnten im Inneren des Schutzgehäuses und somit elektromagnetisch abgeschirmt in dem Innenraum weitere elektronische Bauteile und elektronische Schaltungen vorgesehen sein.

Gemäß einem weiteren Aspekt der Erfindung wird die Vorrichtung als Bewegungsmelder, als Präsenzmelder oder als Wärmebildkamera verwendet. Für einen Bewegungsmelder kann eine Vorrichtung mit einem einzigen Detektorelement ausreichend sein. Für einen Präsenzmelder kann die Vorrichtung mit mehreren Detektorelementen ausgestattet sein. Für die Wärmebildkamera ist die Vorrichtung mit einer Vielzahl von Detektorelementen, beispielsweise 240 x 320 Detektorelemente (QVGA-Standard) und mehr, ausgestattet. Dies ist durch die einfache und Platz sparende Verdrahtung der Detektorelemente möglich.

Zusammenfassend sind folgende Vorteile der Erfindung hervorzuheben:
- Die Vorrichtung zur Detektion von Wärmestrahlung ist kompakt.
- Der Stapel ist elektromagnetisch abgeschirmt und gut von außen zugänglich.
- Zusätzlich können elektronische Bauteile und Schaltungen elektromagnetisch abgeschirmt bereitgestellt sein.
- Die Herstellung der Vorrichtung ist einfach und kostengünstig, da weder eine hermetisch dichte Verbindung zwischen dem Schutzgehäuse und dem Substrat vorgesehen zu werden braucht, noch in die Öffnung des Schutzgehäuses ein Glasfenster hermetisch dicht eingesetzt zu werden braucht, noch der Innenraum des Schutzgehäuses evakuiert oder mit Intertgas beaufschlagt werden muss.

Anhand mehrerer Ausführungsbeispiele und der dazugehörigen Figuren wird im Folgenden eine Vorrichtung zur Detektion von Wärmestrahlung vorgestellt. Die Figuren sind schematisch und stellen keine maßstabsgetreuen Abbildungen dar.
Figur 1 zeigt einen Stapel in einem seitlichen Querschnitt.
Figur 2 zeigt den Stapel aus Figur 1 entlang der Querschnittsflächen B-B in Aufsicht auf die Abdeckung.
Figur 3 zeigt den Stapel aus Figur 1 entlang der Querschnittsflächen A-A in Aufsicht auf den Detektorträger.
Figur 4 zeigt den Stapel aus Figur 1 entlang der Querschnittsflächen A-A in Aufsicht auf den Schaltungsträger.
Figur 5 zeigt ein Detektorelement auf einem Detektorträger in einem seitlichen Querschnitt.
Figur 6 zeigt eine erfindungsgemäße Vorrichtung zur Detektion von Wärmestrahlung in einem seitlichen Querschnitt.
Figur 7 zeigt eine herkömmliche Vorrichtung zur Detektion von Wärmestrahlung in einem seitlichen Querschnitt.

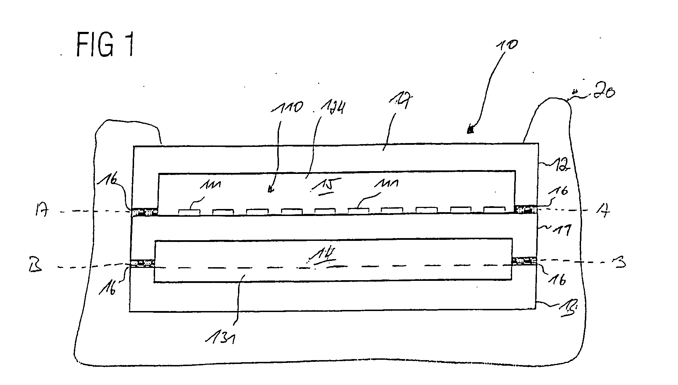

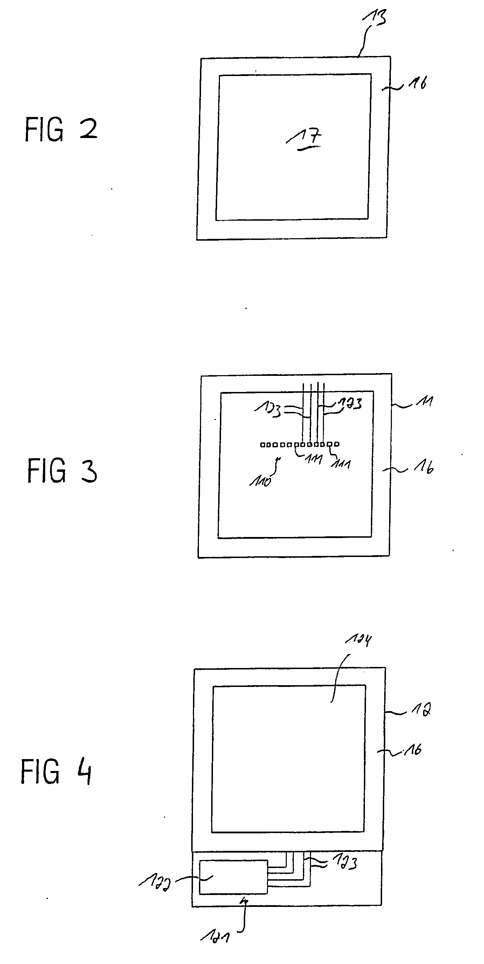

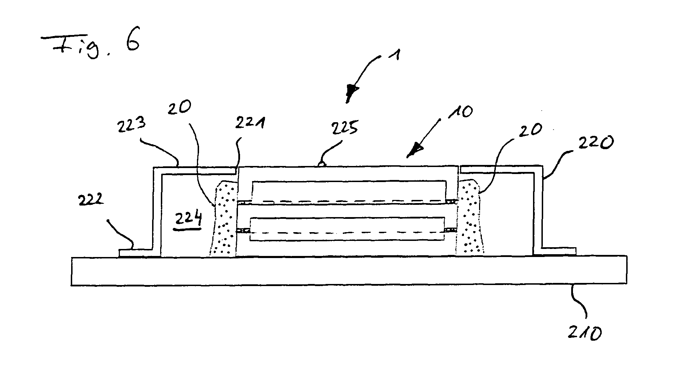

Wie es aus Figuren 1 bis 6 ersichtlich ist, weist eine Vorrichtung zur Detektion von Wärmestrahlung ein Substrat 210 auf, auf dem ein Stapel 10 angeordnet ist. Der Stapel 10 weist eine dem Substrat 210 abgewandte Stapeloberseite 225 auf und ist mit dem Substrat 210 mittels einer Vergussmasse 20 befestigt.

Ferner weist die Vorrichtung 1 ein Schutzgehäuse 220 auf, in dem der Stapel 10 untergebracht ist. Das Schutzgehäuse 220 ist aus Metall hergestellt, so dass der Stapel 10 durch das Schutzgehäuse 220 elektromagnetisch nach außen abgeschirmt ist.

Das Schutzgehäuse 220 weist eine Oberseite 223 auf, die dem Substrat 210 abgewandt angeordnet ist. In der Oberseite 223 ist eine Öffnung 221 vorgesehen, in die der Stapel 10 mit seiner Oberseite 225 eingreift, so dass die Oberseite 223 des Schutzgehäuses 220 und die Oberseite 225 des Stapels 10 plan miteinander abschließen. Ferner ist die Umfangskontur der Öffnung 221 derart ausgebildet, dass an der Stapeloberseite 225 der Stapel 10 in geringem Abstand von der Oberseite 223 des Schutzgehäuses 220 benachbart ist.

Ferner weist das Schutzgehäuse 220 einen der Oberseite 225 abgewandten und dem Substrat 210 zugewandten Fuß 222 auf, der als ein Flansch ausgebildet ist. Der Fuß 222 ist mittels einem Verbindungsmittel, wie zum Beispiel Löten, an dem Substrat 210 befestigt.

Im Inneren des Schutzgehäuses 220 ist um den Stapel 10 ein Innenraum 224 vorgesehen, der von dem Schutzgehäuse 220 elektromagnetisch abgeschirmt ist.

Der Stapel 10 ist mit einem Detektorträger 11 mit einem Detektorarray 110 von thermischen Detektorelementen 111 zur Umwandlung der Wärmestrahlung in elektrische Signale, einem Schaltungsträger 12 mit einer Ausleseschaltung 121 zum Auslesen der elektrischen Signale, und mindestens einer Abdeckung 13 zum Abdecken der Detektorelemente versehen, wobei der Detektorträger und die Abdeckung derart aneinander angeordnet sind, dass zwischen den Detektorelementen des Detektorträgers und der Abdeckung ein, vom Detektorträger und von der Abdeckung begrenzter, erster Stapelhohlraum 14 des Stapels vorhanden ist, der Schaltungsträger und der Detektorträger derart aneinander angeordnet sind, dass zwischen dem Detektorträger und dem Schaltungsträger mindestens ein, vom Schaltungsträger und vom Detektorträgerbegrenzter, zweiter Stapelhohlraum 15 des Stapels vorhanden ist und der erste Stapelhohlraum und/oder der zweite Stapelhohlraum evakuiert sind.

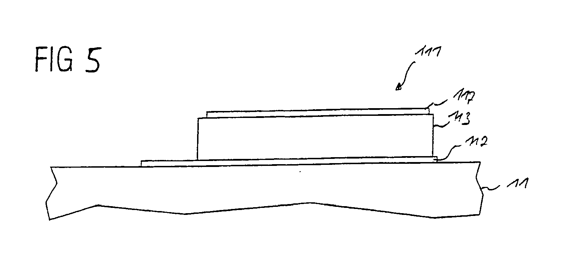

Die Detektorelemente sind pyroelektrische Detektorelemente in Dünnschichtbauweise mit zwei Elektrodenschichten 112 und einer zwischen den Elektrodenschichten angeordneten pyroelektrischen Schicht 113 (Figur 5). Die pyroelektrische Schicht ist eine ca. 1 µm dicke Schicht aus PZT als pyroelektrisch sensitives Material. Die Elektrodenschichten sind aus-Platin und einer Chrom-Nickel-Legierung mit Schichtdicken von etwa 20 nm.

Die Ausleseschaltung weist ein auf dem Schaltungsträger angeordnetes Ausleseelement 122 in Form eines ASICs auf. Gemäß einer nicht dargestellten Ausführungsform ist das Ausleselement im Schaltungsträger integriert.

Der Detektorträger, der Schaltungsträger und die Abdeckung sind jeweils Siliziumsubstrate. Die Detektorelemente sind innerhalb des zweiten Stapelhohlraums gegenüber einer Schaltungsträgerausnehmung 124 des Schaltungsträgers angeordnet. Im Bereich der Schaltungsträgerausnehmung ist ein gemeinsames Bestrahlungsfenster 17 angeordnet, durch das die Wärmestrahlung auf Detektorelemente gelangt. Die Bestrahlung erfolgt von der Vorderseite aus. Gemäß einer nicht dargestellten alternativen Ausgestaltung erfolgt die Bestrahlung von der Rückseite aus. Dazu ist in der Abdeckung und im Detektorträger jeweils ein geeignetes Bestrahlungsfenster ausgebildet.

In der Abdeckung 13 ist eine Abdeckungsausnehmung 131 vorhanden. Diese Abdeckungsausnehmung kann aber auch weggelassen werden, wie es in Figur 1 durch die strichlierten Linie angedeutet ist.

Sowohl der Detektorträger und die Abdeckung als auch der Detektorträger und der Schaltungsträger sind durch einen hermetischen Stoffschluss 16 fest miteinander verbunden. Gemäß einer ersten Ausführungsform besteht der Stoffschluss aus einem Lot. Die Träger (Siliziumsubstrate) sind miteinander verlötet. Alternativ dazu weist der Stoffschluss einen Klebstoff auf. Die Träger sind zusammengeklebt.

Durch den Stoffschluss zwischen dem Schaltungsträger und dem Detektorträger ist für eine elektrische Verdrahtung 123 der Detektorelemente gesorgt. Über die Verdrahtung bzw. Über die Ausleseschaltung werden die elektrischen Signale der Detektorelemente ausgelesen. Alternativ dazu erfolgt die Verdrahtung mittels Flip-Chip.

Während des Herstellens der Stoffschlüsse wird Vakuum angelegt, so dass sich ein Unterdruck in den entstehenden Stapelhohlräumen ausbildet. Die Stapelhohlräume werden bei deren Bildung evakuiert. Alternativ dazu werden die Stapelhohlräume nach dem Herstellen der Stoffschlüsse evakuiert.

Nach dem Herstellen des Stapels wird der Stapel mit einer Umhüllung 20 versehen. Dazu wird ein unvernetzter Kunststoff in einem Spritzgussverfahren auf den Stapel aufgetragen und anschließend vernetzt. Alternativ dazu wird ein Moldverfahren durchgeführt. Dabei wird dafür gesorgt, dass das Bestrahlungsfenster der Abdeckung frei bleibt, also nicht bedeckt wird.

Zum Herstellen des Stapels werden der Detektorträger mit dem Detektorarray, der Schaltungsträger mit der Ausleseschaltung und die Abdeckung bereitgestellt und wie oben beschrieben fest miteinander verbunden. Das Herstellen erfolgt dabei auf Wafer-Ebene. Dazu werden Silizium-Wafer mit einer Vielzahl von entsprechenden Funktionalitäten (Detektorarrays, Ausleseschaltungen, Abdeckungsausnehmungen) versehen. Es werden auf Wafer-Ebene Detektorträger, Schaltungsträger und Abdeckung bereitgestellt. Diese funktionalisierten Silizum-Wafer werden wie oben beschrieben fest miteinander verbunden. Es wird ein Wafer-Stapel mit einer Vielzahl von Einzel-Stapeln hergestellt. Nach dem Verbinden werden die EinzelStapel durch Zersägen des Wafer-Stapels vereinzelt und mit jeweils einer Umhüllung versehen.

Verwendung findet die Vorrichtung in einem Bewegungsmelder oder Präsenzmelder. Für die Anwendung in einer Wärmebildkamera ist eine Vielzahl Stapeln bzw. von Vorrichtungen mit jeweils einem Stapel vorhanden.

## Patentansprüche

1. Vorrichtung (1) zur Detektion von Wärmestrahlung, aufweisend ein Substrat (210), ein auf dem Substrat (210) angebrachtes und ein elektrisch leitendes Material aufweisendes Schutzgehäuse (220) mit einer dem Substrat (210) abgewandten Oberseite (223), in der eine Öffnung (221) vorgesehen ist, und einen auf dem Substrat (210) innerhalb des Schutzgehäuses (220) angebrachten Stapel (10) mit mindestens einem Detektorträger (11) mit mindestens einem thermischen Detektorelement (111) zur Umwandlung der Wärmestrahlung in ein elektrisches Signal, mindestens einem Schaltungsträger (12) mit mindestens einer Ausleseschaltung (121) zum Auslesen des elektrischen Signals, und mindestens einer Abdeckung (13) zum Abdecken des Detektorelements (111), wobei der Detektorträger (11) zwischen dem Schaltungsträger (12) und der Abdeckung (13) angeordnet ist, der Detektorträger (11) und die Abdeckung (13) derart aneinander angeordnet sind, dass zwischen dem Detektorelement (111) des Detektorträgers (11) und der Abdeckung (13) mindestens ein, vom Detektorträger (11) und von der Abdeckung (13) begrenzter, erster Stapelhohlraum (14) des Stapels (10) vorhanden ist, der Schaltungsträger (12) und der Detektorträger (11) derart aneinander angeordnet sind, dass zwischen dem Detektorträger (11) und dem Schaltungsträger (12) mindestens ein, vom Schaltungsträger (1.2) und vom Detektorträger (11) begrenzter, zweiter Stapelhohlraum (15) des Stapels (10) vorhanden ist, wobei der Stapel (10) eine Sandwich-Struktur aus dem Detektorträger (11), dem Schaltungsträger (12) und der Abdeckung (13) hat, und wobei der Stapel (10) eine dem Substrat (210) abgewandte Stapeloberseite (225) aufweist, mit der der Stapel (10) mit der Öffnung (221) in Eingriff steht, so dass die Stapeloberseite (225) von außerhalb des Schutzgehäuses (220) zugänglich ist.

2. Vorrichtung nach Anspruch 1, wobei der Detektorträger (11), der Schaltungsträger (12) und/oder die Abdeckung (13) mindestens ein Bestrahlungsfenster (17) mit einer bestimmten Transmission für die Wärmestrahlung zum Bestrahlen des Detektorelements (111) mit der Wärmestrahlung aufweisen.

3. Vorrichtung nach Anspruch 1 oder 2, wobei der Detektorträger (11), der Schaltungsträger (12) und/oder die Abdeckung (13) Silizium aufweisen.

4. Vorrichtung nach einem der Ansprüche 1 bis 3, wobei das Detektorelement (111) gegenüber einer Schaltungsträgerausnehmung (124) des Schaltungsträgers (12) oder gegenüber einer Abdeckungsausnehmung (131) der Abdeckung (13) angeordnet ist.

5. Vorrichtung nach einem der Ansprüche 1 bis 4, wobei der Detektorträger (11) und der Schaltungsträger (12) und/oder der Detektorträger (11) und die Abdeckung (13) durch einen Stoffschluss (16) und insbesondere durch einen hermetischen Stoffschluss (16) fest miteinander verbunden sind.

6. Vorrichtung nach Anspruch 5, wobei der Stoffschluss (16) einen elektrisch leitfähigen Stoff aufweist.

7. Vorrichtung nach einem der Ansprüche 1 bis 6, wobei mindestens ein Detektorarray (110) mit mehreren Detektorelementen (111) vorhanden ist.

8. Vorrichtung nach einem der Ansprüche 1 bis 7, wobei der Stapel (10) eine Umhüllung (20) aufweist, mit der der Stapel (10) auf dem Substrat (210) festgelegt ist.

9. Vorrichtung nach Anspruch 8, wobei die Umhüllung (20) eine Vergussmasse aufweist.

10. Vorrichtung nach einem der Ansprüche 1 bis 9, wobei das elektrisch leitende Material des Schutzgehäuses (220) Metall aufweist.

11. Vorrichtung nach einem der Ansprüche 1 bis 10, wobei die Öffnung (221) derart ausgebildet ist, dass der Stapel (10) in die Öffnung (221) eingepasst ist.

12. Vorrichtung nach einem der Ansprüche 1 bis 11, wobei das Schutzgehäuse (220) derart konstruiert ist, dass ihre Oberseite (223) mit der Stapeloberseite (225) plan abschließt.

13. Vorrichtung nach einem der Ansprüche 1 bis 12, wobei das Schutzgehäuse (220) einen Fuß (222) aufweist, mit dem das Schutzgehäuse (220) an dem Substrat (210) befestigt ist.

14. Vorrichtung nach einem der Ansprüche 1 bis 13, wobei das Schutzgehäuse (220) im Abstand von dem Stapel (10) angeordnet ist, so dass im Inneren des Schutzgehäuses (220) zwischen dem Schutzgehäuse (220) und dem Stapel (10) ein Hohlraum (224) ausgebildet ist.

## Claims

1. Device (1) for the detection of thermal radiation, comprising a substrate (210), a protective housing (220) attached on the substrate (210) and comprising an electric conductive material, wherein the protective housing (220) comprises an upper side (223) facing away from the substrate (210), wherein in the upper side (223) an opening (221) is provided, and a stack (10) attached on the substrate (210) inside the protective housing (220) with at least one detector support (11) comprising at least one thermal detector element (111) for the conversion of the thermal radiation into an electric signal, at least one circuit support (12) with at least one readout circuit (121) for reading out the electrical signal, and at least one cover (13) for covering the detector element (111), wherein the detector support (11) is arranged between the circuit support (12) and the cover (13), the detector support (11) and the cover (13) are attached to one another such that at least one first stack cavity (14) bordered by the detector support (11) and the cover (13) is present between the detector element (111) of the detector support (11) and the cover (13), the circuit support (12) and the detector support (11) are attached to another such that at least one second stack cavity (15) bordered by the circuit support (12) and the detector support (11) is present between the detector support (11) and the circuit support (12), wherein the stack (10) has a sandwich structure composed of the detector support (11), the circuit support (12) and the cover (13), and wherein the stack (10) comprises an upper stack side (225) facing away from the substrate (210), wherein the stack (10) is in engagement which the opening (221), so that the stack upper surface (225) is accessible from outside of the protective housing (220).

2. Device according to claim 1, wherein the detector support (11), the circuit support (12) and/or the cover (13) comprise at least one irradiation window (17) with a certain transmittance for the thermal radiation for the irradiation of the detector element (111) with the thermal radiation.

3. Device according to claim 1 or 2, wherein the detector support (11), the circuit support (12) and/or the cover (13) comprise silicon.

4. Device according to anyone of the claims 1 to 3, wherein the detector element (111) is arranged opposite to a circuit support recess (124) of the circuit support (12) or opposite to a cover recess (131) of the cover (13).

5. Device according to anyone of the claims 1 to 4, wherein the detector support (11) and the circuit support (12) and/or the detector support (11) and the cover (13) are fixedly attached to each other by a material bond (16) and in particular by a hermetic material bond (16).

6. Device according to claim 5, wherein the material bond (16) comprises an electric conductive substance.

7. Device according to anyone of the claims 1 to 6, wherein at least one detector array (110) with multiple detector elements (111) is present.

8. Device according to anyone of the claims 1 to 7, wherein the stack (10) comprises an encasement (20), with which the stack (10) is located on the substrate (210).

9. Device according to claim 8, wherein the encasement (20) comprises a casting compound.

10. Process according to anyone of the claims 1 to 10, wherein the electric conductive material of the protective housing (220) comprises metal.

11. Device according to anyone of the claims 1 to 10, wherein the opening (221) is formed such that the stack (10) is fitted into the opening (221).

12. Device according to anyone the claims 1 to 11, wherein the protective housing (220) is constructed such that its upper surface (223) is planar with the stack upper side (225).

13. Device according to anyone of the claims 1 to 12, wherein the protective housing (220) comprises a foot (222), with which the protective housing (220) is attached to the substrate (210).

14. Device according to anyone of the claims 1 to 13, wherein the protective housing (220) is arranged in a distance from the stack (10), so that in the inside of the protective housing (220) a cavity (224) is formed between the protective housing (220) and the stack (10).

## Revendications

1. Dispositif (1) pour la détection d'un rayonnement thermique, comprenant un substrat (210), un boîtier de protection (220), qui est posé sur le substrat (210) et comporte un matériau électroconducteur et qui est muni d'une face supérieure (223), opposée au substrat (210) et munie d'une ouverture (221), et un empilement (10), posé sur le substrat (210) à l'intérieur du boîtier de protection (220) et comprenant au moins un porte-détecteur (11) avec au moins un élément de détection (111) thermique pour transformer le rayonnement thermique en un signal électrique, au moins un support de circuits imprimés (12) contenant au moins un circuit de lecture (121) pour la lecture du signal électrique, et au moins un couvercle (13) pour masquer l'élément de détection (111), le porte-détecteur (11) étant disposé entre le support de circuits imprimés (12) et le couvercle (13), le porte-détecteur (11) et le couvercle (13) étant disposés l'un contre l'autre de telle sorte qu'entre l'élément de détection (111) du porte-détecteur (11) et le couvercle (13) il se forme au moins une première cavité (14) dans l'empilement (10), délimitée par le porte-détecteur (11) et le couvercle (13), le support de circuits imprimés (12) et le porte-détecteur (11) étant disposés l'un contre l'autre, de telle sorte qu'entre le porte-détecteur (11) et le support de circuits imprimés (12) il se forme au moins une deuxième cavité (15) dans l'empilement (10), délimitée par le support de circuits imprimés (12) et le porte-détecteur (11), l'empilement (10) ayant une structure sandwich constituée du porte-détecteur (11), du support de circuits imprimés (12) et du couvercle (13), et l'empilement (10) comportant une face supérieure (225) opposée au substrat (210), par laquelle l'empilement (10) est engagée dans l'ouverture (221), de telle sorte que la face supérieure (225) de l'empilement est accessible de l'extérieur du boîtier de protection (220).

2. Dispositif selon la revendication 1, dans lequel le porte-détecteur (11), le support de circuits imprimés (12) et/ou le couvercle (13) comportent au moins une fenêtre d'irradiation (17) avec un coefficient de transmission spécifique au rayonnement thermique, afin de projeter le rayonnement thermique sur l'élément de détection (111).

3. Dispositif selon la revendication 1 ou 2, dans lequel le porte-détecteur (11), le support de circuits imprimés (12) et/ou le couvercle (13) contiennent du silicium.

4. Dispositif selon l'une des revendications 1 à 3, dans lequel l'élément de détection (111) est situé en regard d'un évidement (124), ménagé dans le porte-détecteur (12), ou en regard d'un évidement (131), ménagé dans le couvercle (13).

5. Dispositif selon l'une des revendications 1 à 4, dans lequel le porte-détecteur (11) et le support de circuits imprimés (12) et/ou le porte-détecteur (11) et le couvercle (13) sont assemblés de manière fixe entre eux par liaison de matière (16) et en particulier par une liaison de matière (16) hermétique.

6. Dispositif selon la revendication 5, dans lequel la liaison de matière (16) comporte une matière électroconductrice.

7. Dispositif selon l'une des revendications 1 à 6, dans lequel est présent au moins un ensemble de détecteurs (110) comportant plusieurs éléments de détection (111).

8. Dispositif selon l'une des revendications 1 à 7, dans lequel l'empilement (10) comporte une enveloppe (20), par laquelle l'empilement (10) est fixé sur le substrat (210).

9. Dispositif selon la revendication 8, dans lequel l'enveloppe (20) comporte une pâte de scellement.

10. Dispositif selon l'une des revendications 1 à 9, dans lequel le matériau électroconducteur du boîtier de protection (220) est un métal.

11. Dispositif selon l'une des revendications 1 à 10, dans lequel l'ouverture (221) est réalisée de telle sorte que l'empilement (10) est ajusté dans l'ouverture (221).

12. Dispositif selon l'une des revendications 1 à 11, dans lequel le boîtier de protection (220) est construit de telle sorte que sa face supérieure (223) est située à fleur de la face supérieure (225) de l'empilement.

13. Dispositif selon l'une des revendications 1 à 12, dans lequel le boîtier de protection (220) comporte un pied (222) par lequel le boîtier de protection (220) est fixé sur le substrat (210).

14. Dispositif selon l'une des revendications 1 à 13, dans lequel le boîtier de protection (220) est situé à distance de l'empilement (10) de telle sorte qu'à l'intérieur du boîtier de protection (220) il se forme une cavité (224) entre le boîtier de protection (220) et l'empilement (10).
